Europäisches Patentamt

European Patent Office

Office européen des brevets

(19)

(11) Veröffentlichungsnummer: **0 101 751 B1**

# EUROPÄISCHE PATENTSCHRIFT

(45) Veröffentlichungstag der Patentschrift: **21.08.91**

(21) Anmeldenummer: **82107773.2**

(22) Anmeldetag: **25.08.82**

(51) Int. Cl.⁵: **H03K 17/04**, H03K 5/02, H03K 17/08

(54) Transistor-Leistungsverstärker mit verringerten Schaltzeiten.

(43) Veröffentlichungstag der Anmeldung:
**07.03.84 Patentblatt 84/10**

(45) Bekanntmachung des Hinweises auf die
Patenterteilung:
**21.08.91 Patentblatt 91/34**

(84) Benannte Vertragsstaaten:
**DE FR GB**

(56) Entgegenhaltungen:
**FR-A- 1 600 560**        **FR-A- 2 165 489**
**FR-A- 2 366 746**        **US-A- 3 535 557**
**US-A- 3 825 773**        **US-A- 4 028 633**

**PATENTS ABSTRACTS OF JAPAN, Band 5,
Nr. 44(E-50)(716), 24. März 1981& JP - A -
55166314**

(73) Patentinhaber: **IBM DEUTSCHLAND GMBH**
**Pascalstrasse 100**
**W-7000 Stuttgart 80(DE)**

(84) Benannte Vertragsstaaten:
**DE**

Patentinhaber: **International Business Machines Corporation**
**Old Orchard Road**
**Armonk, N.Y. 10504(US)**

(84) Benannte Vertragsstaaten:
**FR GB**

(72) Erfinder: **Sakmann, Walter, Dipl.-Ing.**
**Beethovenstrasse 12**
**W-7033 Herrenberg(DE)**
Erfinder: **Lang, Albrecht**
**Alosenstrasse 51**
**W-7030 Stuttgart-Hedelfingen(DE)**

(74) Vertreter: **Klocke, Peter, Dipl.-Ing.**
**IBM Deutschland GmbH Patentwesen und
Urheberrecht Schönaicher Strasse 220**
**W-7030 Böblingen(DE)**

**Beschreibung**

Die Erfindung betrifft einen für den Impulsbetrieb geeigneten Transistor-Leistungsverstärker mit verringerten Schaltzeiten, mit mindestens einem Endstufentransistor. Derartige Verstärker finden vielfache Anwendung, da sich durch ihren Einsatz die Verlustleistung im Vergleich zum kontinuierlichen Betrieb verringern und damit der Wirkungsgrad verbessern läßt. Außerdem gestatten sie beim Einsatz in digital geregelten elektrischen Antrieben ein sehr genaues Einhalten einer vorgeschriebenen Drehzahl. Sie sind daher überall dort anzutreffen, wo beispielsweise bürstenlose Gleichstrommotoren als Antriebe von Magnetplattenspeichern dienen oder zum Formular- und Typenbandtransport bei Zeilendruckern verwendet werden, die als Ausgabeeinheiten von Datenverarbeitungsanlagen eingesetzt werden.

Wenn bei der Anwendung von im Impulsbetrieb arbeitenden bürstenlosen Gleichstrommotoren Ströme von mehr als 1A mit Schaltfrequenzen im Bereich von 20 bis 200 kHz geschaltet werden müssen, sind kurze Schaltzeiten der Endstufentransistoren des Leistungsverstärkers erforderlich, um ein Überhitzen dieser Transistoren und als Folge davon einen elektrischen Durchbruch zu vermeiden. Die in diesen Transistoren entstehende Verlustleistungswärme ist nämlich außer von der Größe des geschalteten Stromes und der Betriebsspannung auch von der Schaltfrequenz abhängig. Kurze Schaltzeiten der Endstufentransistoren erlauben daher höhere Schaltfrequenen, ohne daß der erwähnte Durchbruch auftritt.

Maßnahmen zur Verringerung der Schaltzeiten von Transistor-Leistungsverstärkern, deren Endstufen auch im Gegentaktbetrieb arbeiten können, sind bereits bekannt. So lehrt die französische Patentschrift 2 366 746, zum Abschalten eines im Sättigungszustand betriebenen Transistors dessen Basis für eine vorgegebene Entsättigungszeitspanne, die von der Speicherzeit des Transistors abhängt, mit einer zusätzlichen Spannung zu beaufschlagen.

Aus JP-A-55 166 314 ist ein Transistor - Leistungsverstärker bekannt, welcher als Endstufe zwei in Reihe geschaltete komplementäre Endstufentransistoren aufweist, von denen der erste mit der Versorgungsspannung und der zweite mit Bezugspotential verbunden ist, wobei jedem Endstufentransistor eine Vorstufe zugeordnet ist, an deren jeweiligen Ausgängen die miteinander verbundenen Basis-Elektroden zweier koplementären Transistoren angeschlossen sind, deren Emitter miteinander verbunden und über einen Kondensator an die Basis des betreffenden Endstufentransistors angeschlossen sind, während der Kollektor des jeweils ersten der komplementären Transistoren mit der Versorgungsspannung und der des jeweils zweiten mit dem Bezugspotential verbunden ist.

Auch aus dem von der Firma Thomson-CSF herausgegebenen "Handbuch Schalttransistoren" sind bereits Schaltungen zum Verringern der Schaltzeiten der Endstufentransistoren von Leistungsverstärkern bekannt. Sie erfordern jedoch spezielle Zusatzspannungen.

Hier will die Erfindung Abhilfe schaffen. Der Erfindung, wie sie in den Ansprüchen gekennzeichnet ist, liegt die Aufgabe zugrunde, einen für den Impulsbetrieb geeigneten Transistor-Leistungsverstärker mit verringerten Schaltzeiten anzugeben, der ohne zusätzliche spezielle Hilfsspannungen auskommt. Außerdem soll bei dem als Gegentaktstufe ausgeführten Leistungsverstärker erfindungsgemäß ein gleichzeitiges Leiten der beiden in Reihe liegenden Endstufentransistoren mit Sicherheit vermieden werden. Sonst würde nämlich der erwähnte elektrische Durchbruch auch als Folge davon hervorgerufen werden.

Im folgenden wird die Erfindung in Verbindung mit den Zeichnungen näher erläutert, von denen zeigen:

Fig. 1    die grundsätzliche Anordnung der für die elektronische Kommutierung eines bürstenlosen Gleichstrommotors mit der Erregerwicklung W benötigten beiden Leistungsverstärker, deren jeder durch zwei in Reihe liegende komplementäre Ausgangstransistoren T1, T2 bzw. T3, T4 dargestellt ist;

Fig. 2    die grundsätzliche Anordnung der für die elektronische Kommutierung eines dreiphasigen bürstenlosen Gleichstrommotors mit den in Stern geschalteten Erregerwicklungen W1, W2 und W3 benötigten Leistungsverstärker;

Fig. 3    ein Detailschaltbild eines ersten Ausführungsbeispieles für den Leistungsverstärker gemäß der Erfindung;

Fig. 4    ein Detailschaltbild eines zweiten Ausführungsbeispieles für einen Leistungsverstärker gemäß der Erfindung, bei dem die Endstufentransistoren als Darlington-Schaltungen ausgeführt sind;

Fig. 5    Spannungsverläufe an verschiedenen Punkten des Leistungsverstärkers gemäß der Erfindung.

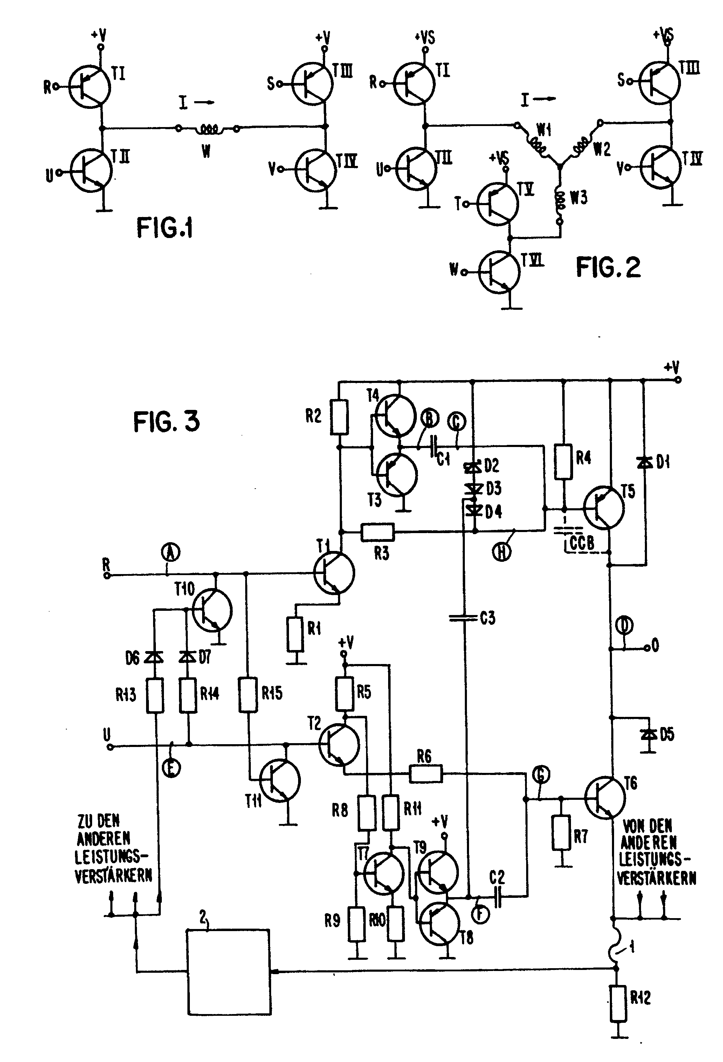

Die prinzipielle Wirkungsweise der elektronischen Kommutierung eines bürstenlosen Gleichstrommotors wird anhand der Fig. 1 kurz erläutert. Wenn die Erregerwicklung W des Motors von einem von links nach rechts fließenden Strom I durchflossen werden soll, werden der Transistor TI des linken und der Transistor TIV des rechten Leistungsverstärkers leitend gemacht, während die Transistoren TII und TIII gesperrt bleiben. Damit ist ein geschlossener Stromkreis hergestellt und der Strom I fließt vom Pluspol + V der Versorgungsspannungsquelle durch den Transistor TI, die Erregerwicklung W des Motors und den Transistor TIV zu dem an Masse angeschlossenen Minuspol der Versorgungsspannungsquelle. Der Transistor TIV bleibt während der gesamten Zeit, während der der Strom I die Erregerwicklung von links nach rechts durchfließen soll, leitend. Der Transistor T1 arbeitet aus Gründen der Verlustleistungsverringerung und/oder bei digitaler Regelung, etwa der Motordrehzahl, im Impulsbetrieb. Soll die Stromrichtung durch die Erregerwicklung W umgekehrt werden, werden die Transistoren TI und TIV gesperrt und dafür die Transistoren TIII und TII leitend gemacht, von denen jetzt der Transistor TIII im Impulsbetrieb arbeitet.

Fig. 2 zeigt die Anordnung von drei Leistungsverstärkern für den Betrieb eines bürstenlosen Gleichstrommotors, der mit drei in Stern geschalteten Erregerwicklungen W1, W2 und W3 versehen ist. Soll beispielsweise der Strom I die beiden Wicklungen W1 und W2 von links nach rechts durchfließen, werden der Transistor TI des ersten und der Transistor TIV des zweiten Leistungsverstärkers leitend gemacht. In diesem Fall arbeitet der Transistor TI im Impulsbetrieb. Soll der Strom I in der umgekehrten Richtung die Erregerwicklungen W1 und W2 durchfließen, werden der Transistor TIII des zweiten und der Transistor TII des ersten Leistungsverstärkers leitend gemacht. In diesem Fall arbeitet der Transistor TIII im Impulsbetrieb. Soll der Strom durch die Erregerwicklungen W2 und W3 oder W1 und W3 durchfließen, werden entsprechend der gewünschten Stromflußrichtung die zugehörigen Transistoren der Leistungsverstärker leitend gemacht.

Bei dem in Fig. 3 dargestellten Detailschaltbild für ein erstes Ausführungsbeispiel eines Leistungsverstärkers gemäß der Erfindung sind die beiden Eingänge des zwei komplementäre Endstufentransistoren T5 und T6 aufweisenden Leistungsverstärkers mit R und U bezeichnet. Der Eingang R führt an die Basis des ersten Vorstufentransistors T1, der Eingang U an die Basis des zweiten Vorstufentransistors T2. Der Emitter von T1 ist über den Widerstand R1 an Masse gelegt, sein Kollektor ist einmal über den Widerstand R2 an den positiven Pol + V der Betriebsspannungsquelle und über den Widerstand R3 an die Basis des PNP-Endstufentransistors T5 angeschlossen. An den Kollektor von T1 sind auch die miteinander verbundenen Basis-Elektroden zweier komplementärer Transistoren T3 und T4 angeschlossen. Diese stellen einen im Gegentakt-B-Betrieb arbeitenden komplementären Emitterfolger dar. Die ebenfalls miteinander verbundenen Emitter von T3 und T4 sind über einen Kondensator C1 mit der Basis von T5 verbunden, die über den Widerstand R4 an den positiven Pol + V der Betriebsspannungsquelle angeschlossen ist, mit dem auch der Emitter von T5 verbunden ist. Sein Kollektor ist an den Ausgang O des Leistungsverstärkers angeschlossen. Der Kollektor des NPN-Transistors T4 ist mit dem positiven Pol + V der Betriebsspannungsquelle, der des PNP-Transistors T3 mit dem an Masse angeschlossenen negativen Pol der Betriebsspannungsquelle verbunden. Die Kollektor-Emitterstrecke von T5 ist durch eine Freilauf-Diode D1 überbrückt, deren Kathode an den positiven Pol + V der Betriebsspannungsquelle angeschlossen ist. Mit ihm ist auch die Kathode einer Zener-Diode D2 verbunden, die über die Reihenschaltung zweier Dioden D3 und D4 an die Basis von T5 angeschlossen ist.

Der Kollektor von T2, dessen Basis an den zweiten Eingang U des Leistungsverstärkers angeschlossen ist, ist über den Widerstand R5 mit dem positiven Pol + V der Betriebsspannungsquelle verbunden. Sein Emitter ist über den Widerstand R6 an die Basis des NPN-Endstufentransistors T6 angeschlossen, die über den Widerstand R7 an Masse liegt. An den Kollektor von T6 ist die Kathode einer Freilaufdiode D5 angeschlossen, deren Anode an Masse liegt. An den Kollektor von T2 ist auch eine Reihenschaltung aus den beiden Widerständen R8 und R9 angeschlossen, deren Fußpunkt an Masse liegt. Der Verbindungspunkt der beiden Widerstände R8 und R9 ist an die Basis eines als Inverter dienenden Vorstufentransistor T7 angeschlossen, dessen Emitter über den Widerstand R10 an Masse liegt und dessen Kollektor über den Widerstand R11 an den positiven Pol + V der Betriebsspannungsquelle angeschlossen ist. Der Kollektor von T7 ist an die miteinander verbundenen Basis-Elektroden zweier komplementärer Transistoren T8 und T9 angeschlossen. Deren ebenfalls miteinander verbundene Emitter sind über den Kondensator C2 an die Basis des NPN-Endstufentransistors T6 angeschlossen Dessen Kollektor ist mit dem Ausgang O des Leistungsverstärkers verbunden, während sein Emitter über eine Schmelzsicherung 1 und einen Abfühlwiderstand R12 an Masse liegt. Der Kollektor des NPN-Transistors T9 ist mit dem positiven Pol + V der Betriebsspannungsquelle, der des PNP-Transistors T8 mit dem Massepotential verbunden. Über den Kondensator C3 sind die miteinander verbundenen Emitter von T8 und T9 an den Verbindungspunkt der beiden Dioden D3 und D4 angeschlossen. Über die Schmelzsicherung 1 ist der Emitter von T6 auch mit dem Eingang einer Strombegrenzungsschaltung 2 verbunden, die bei einem dreiphasigen bürstenlosen Gleichstrommotor für dessen drei Leistungsverstärker gemeinsam vorgesehen und in Fig. 3 nur als Block dargestellt ist. Ihr Ausgangssignal wird jeweils über einen Widerstand R13 und eine Diode D6 der Basis eines Überlastungsschutz-Transistors T10 zugeführt, der vom gleichen Leitfähigkeitstyp wie der erste Vorstufentransistor T1 ist und dessen Kollektor mit der Basis dieses Transistors verbunden ist, während sein Emitter an Masse angeschlossen ist. Über einen Widerstand R14 und eine Diode D7 ist der zweite Eingang U des Leistungsverstärkers mit der Basis des Transistors T10 verbunden. Der Eingang R des Leistungsverstärkers ist außerdem über den Widerstand R15 an die Basis eines zweiten Überlastungsschutz-Transistors T11 angeschlossen, der vom gleichen Leitfähigkeitstyp wie der zweite Vorstufentransistor T2 ist und dessen Kollektor mit der Basis von T2 und dessen Emitter mit Masse verbunden ist.

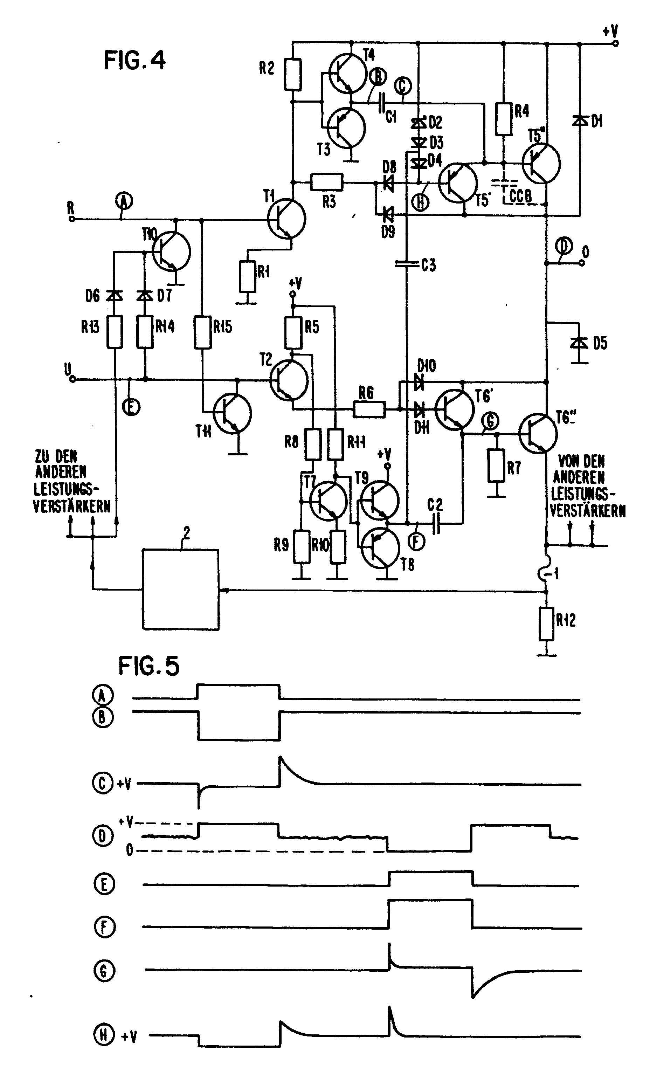

Zur Erläuterung der Wirkungsweise des Leistungsverstärkers nach Fig. 3 in Verbindung mit den Impulsdiagrammen der Fig. 5 wird davon ausgegangen, daß der Leistungsverstärker bisher inaktiv war, das heißt, beide Endstufentransistoren T5 und T6 nichtleitend waren und damit auch die Vorstufentransistoren T1 und T2. In diesem Zustand ist das Potential am Kollektor des Transistors T1 gleich der Spannung +V der Betriebsspannungsquelle. Daher hat auch das Potential der miteinander verbundenen Basis-Elektroden der beiden komplementären Transistoren T3 und T4 den Wert +V. Der NPN-Transistor T4 ist bei positivem Basispotential leitend, so daß auch das Potential der miteinander verbundenen Emitter von T3 und T4 etwa den Wert +V besitzt (Kurve B in Fig. 5). Jetzt soll beispielsweise ein Stromfluß durch die in Fig. 1 dargestellte Motorwicklung W von links nach rechts erfolgen. Dazu wird der Endstufentransistor T5, der dem Transistor TI in Fig. 1 entspricht, leitend gemacht, während der Endstufentransistor T6, der dem Transistor TII in Fig. 1 entspricht, gesperrt bleibt. In dem dem rechten Ende der Wicklung W zugeordneten Leistungsverstärker mit den Endstufentransistoren TIII und TIV wird der Transistor TIV leitend gemacht und der Transistor TIII bleibt gesperrt.

Um den Transistor T5 in Fig. 3 leitend zu machen, wird dem Eingang R des Leistungsverstärkers ein positiver Impuls, beispielsweise ein TTL-Pegel von 5V zugeführt (Kurve A in Fig. 5). Dadurch wird der NPN-Vorstufentransistor T1 leitend, so daß jetzt der Basisstrom des Endstufentransistors T5 von dem positiven Pol +V der Betriebsspannungsquelle über die Basis-Emitterdiode von T5, den Widerstand R3, den Vorstufentransistor T1 und dessen Emitterwiderstand R1 zum Minuspol der Betriebsspannungsquelle fließen kann. Damit beginnt der Endstufentransistor T5 Strom an die Motorwicklung W zu liefern.

Eine verkürzte Einschaltzeit dieses Transistors wird durch die Schaltungskombination aus dem Widerstand R2, den komplementären Transistoren T3 und T4 sowie dem Kondensator C1 in der nachfolgend beschriebenen Weise erreicht: Bei leitendem Transistor T1 ruft der über den Widerstand R2 fließende Teil des Kollektorstromes an diesem Widerstand einen Spannungsabfall von beispielsweise 6 Volt hervor (Kurve B in Fig. 5). Dadurch wird das Potential der miteinander verbundenen Basiselektroden der Transistoren T3 und T4 abgesenkt. Sobald das Basispotential um etwa 0,6 V gegenüber dem Emitterpotential abgesenkt wird, wird der PNP-Transistor T3 leitend und der NPN-Transistor T4 gesperrt. T3 überträgt den Potentialsprung am Kollektor von T1 und damit an den Basiselektroden von T3 und T4 zu deren Emitter. T3 bleibt solange leitend, bis sein Emitter- und Basispotential etwa gleich geworden sind. Die Änderung des Emitterpotentials wird durch den Kondensator C1 auf die Basis des Endstufentransistors T5 übertragen, deren Potential dadurch kurzzeitig stärker negativ wird (Kurve C) und ein schnelleres Einschalten von T5 durch Basisstromüberhöhung bewirkt.

Auch das Ausschalten des Transistors T5 erfolgt aufgrund der Schaltungskombination aus dem Widerstand R2, den komplementären Transistoren T3 und T4 sowie dem Kondensator C1 beschleunigt. Wenn der Vorstufentransistor T1 durch Beenden des seiner Basis zugeführten positiven Steuerimpulses gesperrt wird, wird damit auch der Emitter-Basisstromkreis von T5 unterbrochen, so daß dieser Transistor nichtleitend wird. Dieser Vorgang wird durch den positiven Potentialsprung am Kollektor von T1 beschleunigt, durch den auch das Basispotential des NPN-Transistors T4 angehoben wird. Sobald es um etwa 0,6 Volt gegenüber dem Emitterpotential angehoben wurde, wird der NPN-Transistor T4 wieder leitend und der PNP-Transistor T3 gesperrt. Der leitende Transistor T4 überträgt den Potentialsprung am Kollektor von T1 und damit an den Basiselektroden von T3 und T4 zu deren Emittern. T4 bleibt solange leitend, bis sein Emitter- und Basispotential etwa gleich geworden sind. Über den Kondensator C1 wird dieser positive Potentialsprung auf die Basis von T5 übertragen. Dieser wird durch die ihm zusätzlich durch C1 zugeführten positiven Ladungsträger, die ein beschleunigtes Ausräumen der Basis bewirken, rascher gesperrt. Nach dem Ausschalten von T5 wird der Punkt C über den Widerstand R4 wieder auf das Potential +V gebracht, d.h. der Kondensator C1 wird über den Transistor T4 und den Widerstand R4 entladen.

Die Schaltzeiten des komplementären Endstufentransistors T6 werden in entsprechender Weise verringert. Da der Vorstufentransistor T2 wie der Vorstufentransistor T1 ein NPN-Transistor ist, der mit TTL-Pegeln angesteuert werden soll, ist für die Ansteuerung des zu T5 komplementären Endstufentransistors T6 noch das Einfügen eines als Phasenumkehrstufe dienenden Vorstufentransistor T7 erforderlich. Dieser Transistor ist bei gesperrtem Vorstufentransistor T2 aufgrund der dann an dem aus den Widerständen R5, R8 und R9 gebildeten Spannungsteiler entstehenden Basisspannung leitend. Soll der Endstufentransistor T6 leitend gemacht werden, wird der Basis von T2 ein positiver Impuls zugeführt, der diesen Transistor leitend macht. Sein Emitterstrom wird über den Widerstand R6 als Basisstrom dem Endstufentransistor T6 zugeführt, wodurch dieser zu leiten beginnt. In Folge des beim Leiten von T2 an dessen Kollektorwiderstand R5 auftretenden Spannungsabfalls liegt an dem mit der Basis von T7 verbundenen Abgriff des Spannungsteilers aus R5, R8 und R9 jetzt eine geringere Basisspannung, so daß T7 gesperrt wird. Dadurch steigt sein Kollektorpotential und damit das Potential der miteinander verbundenen Basiselektroden der beiden komplementären Transistoren T8 und T9 an. Der NPN-Transistor T9 wird bei positivem Basispotential leitend, so daß auch das Potential der beiden miteinander verbundenen Emitter von T8 und T9 ansteigt (Kurve F). Über den Kondensator C2 wird die Änderung des Emitterpotentials von T8 und T9 als positiver Nadelimpuls zur Basis des Endstufentransistors T6 übertragen, der durch die seiner Basis zusätzlich zugeführten Ladungsträger beschleunigt leitend wird.

Auch das Ausschalten von T6 erfolgt gemäß der Erfindung rascher. Beim Sperren des Vorstufentransistors T2 wird der Basis-Emitterstromkreis von T6 unterbrochen. Dieser beginnt daher nichtleitend zu werden. Durch das Sperren von T2 steigt dessen Kollektorpotential und damit auch das der an den Abgriff des aus den Widerständen R5, R8 und R9 gebildeten Spannungsteilers angeschlossenen Basis von T7. Dieser Transistor wird leitend. Damit sinkt sein Kollektorpotential, das gleichzeitig das Potential der Basiselektroden von T8 und T9 ist. Bei negativem Basispotential wird T8 leitend, so daß sein Emitterpotential und das von T9 absinkt. Über den Kondensator C2 wird die Potentialänderung als negativer Impuls zur Basis von T6 übertragen, der durch die ihm zusätzlich zugeführten negativen Ladungsträger beschleunigt nichtleitend wird. Nach dem Sperren von T6 weist der Punkt G zunächst ein negatives Potential auf. Über den Widerstand R7 wird sein Potential dann bis auf Massepotential angehoben. Dabei wird der Kondensator C2 nur teilweise entladen.

Wie schon erwähnt, muß ein gleichzeitiges Leiten beider Endstufentransistoren T5 und T6 des Leistungsverstärkers unbedingt vermieden werden, da dann nämlich ein hoher Kurzschlußstrom vom positiven Pol +V der Betriebsstromquelle über die Endstufentransistoren T5 und T6 zum Minuspol fließt, ohne daß die Motorwicklung den Stromfluß begrenzt. Hierdurch würde eine unzulässige Verlustleistung erzeugt, die die Lebensdauer des Leistungsverstärkers stark verringern würde. Die Gefahr des gleichzeitigen Leitens beider Endstufentransistoren ist jedoch, wenn es sich um komplementäre Transistoren handelt, im normalen Betrieb des Leistungsverstärkers dadurch gegeben, daß bei Einschalten des Endstufentransistors T6, der im normalen Betrieb des Leistungsverstärkers die Verbindung mit dem an das Bezugspotential angeschlossenen Pol der Betriebsspannungsquelle herstellt, dessen Kollektorpotential absinkt. Dieser Potentialsprung gelangt jedoch über die in Fig. 3 gestrichelt gezeichnete parasitäre Basis-Kollektorkapazität $C_{CB}$ des gesperrten Endstufentransistors T5 auf dessen Basis und würde ihn ohne Gegenmaßnahmen auch leitend machen. Dieses unerwünschte Leiten beider Endstufentransistoren T5 und T6 wird bei dem Leistungsverstärker nach der Erfindung durch den Kondensator C3, die Zener-Diode D2 und die Dioden D3 und D4 verhindert. Der Kondensator C3 ist zwischen den Verbindungspunkt der beiden Emitter von T8 und T9 mit dem Kondensator C2 und dem Verbindungspunkt der beiden Dioden D3 und D4 geschaltet. Das gleichzeitige Leiten von T5 und T6 wird in folgender Weise verhindert: Wenn beim Einschalten von T6 das Potential an den Emittern von T8 und T9 ansteigt (Kurve F), wird diese Potentialänderung nicht nur über den Kondensator C2 als positiver Nadelimpuls (Kurve G) zur Basis von T6 übertragen, sondern über den Kondensator C3 und die Diode D4 auch auf die Basis des zu T6 komplementären NPN-Endstufentransistors T5 (Kurve H). Dadurch wird die Wirkung des über die Basis-Kollektorkapazität $C_{CB}$ auf die Basis von T5 übertragenen negativen Spannungssprungs am Kollektor von T6 kompensiert und T5 bleibt beim Einschalten von T6 gesperrt. Um ein gleichzeitiges Leiten beider Endstufentransistoren T5 und T6 auch dann zu verhindern, wenn aufgrund eines Fehlers beiden Eingängen R und U des Leistungsverstärkers ein positives Potential zugeführt wird, ist an den Eingang R über den Widerstand R15 die Basis eines NPN-Transistors T11 angeschlossen, dessen Kollektor mit dem zweiten Eingang U des Leistungsverstärkers und dessen Emitter an Masse angeschlossen ist. Ebenso ist über den Widerstand R14 und eine Diode D7 die Basis eines zweiten NPN-Transistors T10 an den zweiten Eingang U anaeschlossen. Sein Kollektor ist mit dem ersten Eingang R, sein Emitter ebenfalls mit Masse verbunden.

Die Wirkungsweise dieser Überlastungs-Schutzschaltung ist folgende: Wenn bei leitendem Vorstufentransistor T1 aufgrund eines Fehlers auch dem zweiten Eingang U des Leistungsverstärkers ein positives Potential zugeführt wird, das ohne eine Überlastungs-Schutzschaltung auch das Leiten von T6 bewirken würde, wird der Transistor T11 leitend und leitet damit den Basisstrom von T2 nach Masse ab, so daß dieser Transistor und damit der zugehörige Endstufentransistor T6 gesperrt bleibt. Umgekehrt leitet der Transistor T10 den Basisstrom des Vorstufentransistors T1 nach Masse ab, wenn bei bereits leitendem Vorstufentransistors T2 ein positives Steuersignal dem ersten Eingang R aufgrund eines Fehlers zugeführt wird.

Der den Basisstrom von T1 im Fehlerfall nach Masse ableitende Transistor T10 wird auch dann durch die Strombegrenzungschaltung 2 aktiviert, wenn beim Start und bei sehr geringen Geschwindigkeiten des bürstenlosen Gleichstrommotors die in der Motorwicklung hervorgerufene gegenelektromotorische Kraft zu gering ist, so daß die Endstufentransistoren der beiden den Stromfluß durch die Motorwicklung ermöglichenden Leistungsverstärker überlastet würden. Der über den Widerstand R13 und die Diode D6 von der Strombegrenzungsschaltung leitend gemachte Transistor T10 verhindert dies durch Ableiten des Basisstromes des ersten Vorstufentransistors T1 nach Masse.

Fig. 4 zeigt das Schaltbild eines zweiten Ausführungsbeispieles eines erfindungsgemäßen Leistungsverstärkers. Es unterscheidet sich von dem nach Fig. 3 lediglich dadurch, daß jeder der Endstufentransistoren T5 und T6 der Fig. 3 in Fig. 4 durch eine Darlington-Schaltung aus zwei diskreten Transistoren T5' und T5'' bzw. T6' und T6'' ersetzt ist. Die Dioden D8 und D9 bzw. D10 und D11 verhindern einen Sättigungsbetrieb der Transistoren T5' und T6', durch den die Schaltzeiten der Darlington-Schaltung verlängert würden. Aufgrund der beiden Dioden D8 und D9 kann das Kollektorpotential von T5' nie über sein Basispotential ansteigen. T5' wird also etwa an der Grenze zur Sättigung betrieben. Der Ausgangstransistor T5'' kann ebenfalls nicht in die Sättigung geraten, da sein Kollektorpotential wegen des zwischen seiner Basis und seinem Kollektor angeordneten Transistors T5' immer niedriger als sein Basispotential ist. Gegenüber dem Schaltbild der Fig. 3 unterscheidet sich das der Fig. 4 auch noch dadurch, daß die Kathode der Diode D4 an die Basis des Transistors T5' der oberen Darlington-Schaltung angeschlossen ist. Die Wirkungsweise der Schaltung nach Fig. 4 entspricht jedoch der nach Fig. 3.

Der bei dem Schaltbild nach Fig. 4 nur für die obere Darlington-Schaltung aus T5' und T5'' vorgesehene Schaltungsteil aus dem Kondensator C3 und den Dioden D2, D3 und D4 kann bei Bedarf, wenn nämlich die Basis-Kollektorkapazität $C_{CB}$ des Transistors T6' und seine Stromverstärkung $\beta$ groß sind, auch für die untere Darlington-Schaltung aus T6' und T6'' vorgesehen werden.

Über den Transistor T8 von dem Kondensator C3 abfließende Ladungsträger werden über die Zener-Diode D2 und die Diode D3 ersetzt. Die Zener-Diode D2 begrenzt den Ladungszufluß und erlaubt ein rascheres Nachladen von C3 als es über einen Widerstand möglich wäre. Diese Maßnahme unterstützt das Erreichen kurzer Schaltzeiten und hoher Schaltfrequenzen.

Bei den den Endstufentransistoren T5 und T6 bzw. T5'' und T6'' parallel geschalteten Dioden D1 und D2 handelt es sich um Freilaufdioden, die beim Impulsbetrieb des Endstufentransistors T5 bzw. T5'' das Auftreten hoher Induktionsspannungen verhindern, da sie beim Sperren dieser Transistoren es dem die Motorwicklung durchfließenden Strom erlauben, in der bisherigen Richtung weiterzufließen.

**Patentansprüche**

1. Elektronischer Kommutierungsschaltkreis für bürstenlose Gleichstrommotoren mit mehreren, der Anzahl der Erregerwicklungen entsprechenden Transistor-Leistungsverstärkern,

   dadurch gekennzeichnet, daß

   jeder Transistor-Leistungsverstärker als Endstufe zwei in Reihe geschaltete komplementäre Endstufentransistoren (T5, T6) aufweist, von denen der erste (T5) mit der Versorgungsspannung ( + V) und der zweite (T6) mit dem Bezugspotential verbunden ist,

   jedem Endstufentransistor eine Vorstufe (T1, T2/T7) zugeordnet ist,

   an den jeweiligen Ausgang einer Vorstufe (T1, T7; Fig. 3) die miteinander verbundenen Basis-Elektroden zweier komplementärer Transistoren (T3, T4; T8, T9) angeschlossen sind,

   jeweils die Emitter der beiden komplementären Transistoren miteinander verbunden und über einen Kondensator (C1, C2) an die Basis des betreffenden Endstufentransistors (T5, T6) angeschlossen sind, während der Kollektor des jeweils ersten der komplementären Transistoren (T4, T9) mit der Versorgungsspannung ( + V) und der des jeweils zweiten (T3, T8) mit dem Bezugspotential verbunden ist,

   die Basis des einen Endstufentransistors (T5) galvanisch über einen Widerstand (R3) mit dem Ausgang der zugehörigen Vorstufe (T1) verbunden ist; die Basis des anderen Endstufentransistors (T6) galvanisch über einen Widerstand (R6) mit der zugehörigen Vorstufe (T2/T7) verbunden ist,

die beiden miteinander verbunden Emitter des Schaltungszweiges, über den der Ausgang einer Vorstufe (T7) mit der Basis des dazugehörigen, das Bezugspotential durchschaltenden Endstufentransistors (T6) verbunden ist, über einen weiteren Kondensator (C3) und eine Diode (D4) mit der Basis des dazu komplementären, die Versorgungsspannung (+V) durchschaltenden Endstufentransistors (T5) verbunden ist, und

der weitere Kondensator (C3) über eine an den positiven Pol (+V) der Betriebsspannungsquelle angeschlossene Zener-Diode (D2) und eine damit in Reihe liegende Diode (D3) nachgeladen wird.

2. Elektronischer Kommutierungsschaltkreis nach Anspruch 1, dadurch gekennzeichnet, daß

jede Vorstufe des Leistungsverstärkers mindestens einen Eingangstransistor (T1, T2) enthält, dessen Basis über einen Widerstand (R14, R15) mit der Basis eines als Überlastungsschutz dienenden Transistors (T10, T11) gleichen Leitfähigkeitstyps wie die zu schützende Vorstufe verbunden ist, dessen Kollektor an den jeweiligen Eingang (R, U) des Leistungsverstärkers und dessen Emitter an das Bezugspotential angeschlossen ist.

3. Elektronischer Kommutierungsschaltkreis nach Anspruch 1 oder 2, dadurch gekennzeichnet, daß die Endstufe als Darlington-Schaltung ausgeführt ist und der genannte Kondensator (C1, C2) an die Basis des jeweiligen Ausgangstransistors (T5'', T6'') der Darlington-Schaltung angeschlossen ist und der Eingangstransistor (T5'; T6') der Darlington-Schaltung mit den Sättigungsbetrieb vermeidenden Schaltungselementen (D8, D9; D10, D11) versehen ist.

4. Elektronischer Kommutierungsschaltkreis nach Anspruch 3, dadurch gekennzeichnet, daß

der weitere Kondensator (C3) über die Diode (D4) mit der Basis des Eingangstransistors (T5') der Darlington-Schaltung verbunden ist.

## Claims

1. Electronic commutation circuit for brushless DC motors with several transistor power amplifiers corresponding to the number of excitation windings,

characterized in that

each transistor power amplifier as a final stage has two series-connected complementary final stage transistors (T5, T6), the first one of which (T5) is connected to the operating voltage (+V) and the second one of which (T6) is connected to the reference potential,

each final stage transistor has an associated prestage (T1, T2/T7),

the interconnected base electrodes of two complementary transistors (T3, T4; T8, T9) are connected to the respective output of a prestage (T1, T7; Fig. 3),

the emitters of the two complementary transistors are interconnected and, through a capacitor (C1, C2) are linked with the base of the associated final stage transistor (T5, T6), whereas the collector of the first one of the complementary transistors (T4, T9) is is connected to the operating voltage (+V) and the second one (T3, T8) is connected to the reference potential,

the base of one final stage transistor (T5) is connected by electroplating through a resistor (R3) to the output of the associated prestage (T1); the base of the other final stage transistor (T6) being connected by electroplating through a resistor (R6) to the associated prestage (T2/T7),

the two interconnected emitters of the circuit section, by which the output of one prestage (T7) is connected to the base of the associated final stage transistor (T6) switching the reference potential, are linked through a further capacitor (C3) and a diode (D4) with the base of the complementary final stage transistor (T5) switching the operating voltage (+V), and

the further capacitor (C3) is reloaded by a zener diode (D2) connected to the positive pole (+V) of the operating voltage source and a diode (D3) series-connected thereto.

2. Electronic commutation circuit as claimed in claim 1, characterized in that

each prestage of the power amplifier comprises at least one input transistor (T1, T2), the base of which is connected through a resistor (R14, R15) to the base of the transistor (T10, T11) used for overload protection and being of the same conductivity type as the prestage to be protected, the collector of said transistor being connected to the respective input (R, U) of the power amplifier and its emitter being connected to the reference potential.

3. Electronic commutation circuit as claimed in claim 1 or 2, characterized in that

the final stage is designed as a Darlington circuit and said capacitor (C1, C2) is connected to the base of the respective output transistor (T5''; T6'') of the Darlington circuit, and the input transistor (T5'; T6') of the Darlington circuit is provided with circuit elements (D8, D9; D10, D11) keeping said transistor out of saturation.

4. Electronic commutation circuit as claimed in claim 3, characterized in that

the further capacitor (C3) is connected to the base of the input transistor (T5') of the Darlington circuit by the diode (D4).

**Revendications**

1. Circuit de commutation électronique pour un moteur à courant continu sans balais, comportant plusieurs amplificateurs de puissance à transistors en un nombre correspondant à celui des enroulements d'excitation,
caractérisé par le fait que
chaque amplificateur de puissance à transistors comporte, en tant qu'étage final, deux transistors complémentaires (T5,T6) branchéc en série, dont le premier (T5) est raccordé à la tension d'alimentation (+V) et dont le second (T6) est raccordé au potentiel de référence,
un étage amont (T1,T2/T7) est associé à chaque transistor de l'étage final,
les électrodes de base, reliées entre elles, de deux transistors complémentaires (T3,T4;T8,T9) sont raccordées à la sortie respective d'un étage d'amont (T1,T7; figure 3),
les émetteurs des deux transistors complémentaires sont reliés respectivement entre eux et sont raccordés, par l'intermédiaire d'un condensateur (C1,C2), à la base du transistor considéré (T5,T6) de l'étage final, tandis que le collecteur du premier des deux transistors complémentaires (T4,T9) est raccordé à la tension d'alimentation (+V) et le collecteur du second transistor (T3,T8) est raccordé au potentiel de référence,
la base d'un premier transistor (T5) de l'étage final est raccordée galvaniquement, par l'intermédiaire d'une résistance (R3), à la sortie de l'étage amont associé (T1); la base de l'autre transistor (T6) de l'étage final est raccordée galvaniquement par l'intermédiaire d'une résistance (R6) à l'étage amont associé (T2/T7), les deux émetteurs, reliés entre eux, du circuit, par l'intermédiaire duquel la sortie d'un étage amont (T7) est raccordée à la base du transistor associé (T6) de l'étage final, qui transmet le potentiel de référence, sont reliés par l'intermédiaire d'un autre condensateur (C3) et d'une diode (D4) à la base du transistor (T5) de l'étage final, qui est complémentaire du transistor précédent et transmet la tension d'alimentation (+V), et
l'autre condensateur (C3) est rechargé par l'intermédiaire d'une diode Zener (D2) raccordée au pôle positif (+V) de la source de tension d'alimentation, et d'une diode (D3) branchée en série avec la précédente.

2. Circuit de commutation électronique selon la revendication 1, caractérisé en ce que chaque étage amant de l'amplificateur de puissance contient au moins un transistor d'entrée (T1,T2), dont la base est raccordée par l'intermédiaire d'une résistance (R14,R15) à la base d'un transistor (T10,T11), qui sert de système de protection contre une surcharge et possède le même type de conductivité que l'étage amont devant être protégé, et dont le collecteur est raccordé à l'entrée respective (R,U) de l'amplificateur de puissance et dont l'émetteur est raccordé au potentiel de référence.

3. Circuit de commutation électronique selon l'une des revendications 1 ou 2, caractérisé en ce que l'étage final est réalisé sous la forme d'un circuit de Darlington et ledit condensateur (C1,C2) est raccordé à la base du transistor respectif de sortie (T5'',T6'') du circuit de Darlington, et le transistor d'entrée (T5',T6') du circuit de Darlington comporte des éléments de circuit (D8,D9; D10,D11) évitant le fonctionnement à la saturation.

4. Circuit de commutation électronique selon la revendication 3, caractérisé en ce que l'autre condensateur (C3) est raccordé, par l'intermédiaire de la diode (D4), à la base du transistor d'entrée (T5') du circuit de Darlington.

FIG.1

FIG.2

FIG. 3

FIG.4

ZU DEN
ANDEREN
LEISTUNGS-
VERSTÄRKERN

VON DEN
ANDEREN
LEISTUNGS-
VERSTÄRKERN

FIG.5